# EUROPEAN PATENT APPLICATION

(11) **EP 4 664 457 A1**
(43) Date of publication of application: **17.12.2025**
(21) Application number: 25172777.2
(22) Date of filing: 28.04.2025
(51) Int. Cl.: G11C 7/22, G06F 1/10

(54) **ULTRA-WIDE BAND AC-COUPLED BUFFER**

(30) Priority: 14.06.2024 US 202418744282
(71) Applicant: INTEL Corporation, Santa Clara, CA 95054 (US)
(72) Inventor: KUMAR, Ashish, 201009 Ghaziabad, UP (IN); DESHPANDE, Vani, 560103i BANGALORE KA (IN); DOUR, Navneet, CA, 95762 (US); JATAVALLABHULA, Srikanth Samatha, 560087 Bangalore, Karnataka (IN); NEDALGI, Dharmaray, 560103 Bangalore KA (IN)
(74) Representative: HGF

(57) **Abstract**

Embodiments herein relate to an alternating-current (AC)-coupled buffer in the path of a clock signal which can accommodate a wide range of clock frequencies while reducing duty cycle settling time and without increasing power consumption or area. The AC-coupled buffer includes a variable-impedance feedback element coupled between the input and output nodes of a complementary metal-oxide semiconductor (CMOS) inverter. The variable-impedance feedback element can include first and second diode-connected transistors.

## Description

### BACKGROUND

Clock signals play an important role in computing devices in synchronizing the operations of various components. Applications include communication of data signals and read/write operations for memory devices. In some cases, an alternating-current (AC)-coupled buffer, also known as a coupling capacitor buffer, is used to remove the direct current (DC) component of a clock signal, allowing only the AC component to pass through. The AC-coupled buffer also provides isolation between different power domains. However, various challenges are presented in designing an AC-coupled buffer.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1A depicts an example clock distribution network 100 or path including an alternating-current (AC) buffer 140 receiving a clock in one supply domain and converting it to another supply domain, in accordance with various embodiments.
FIG. 1B depicts an example implementation of the inverter 143 of FIG. 1A, in accordance with various embodiments.
FIG. 2 depicts example read timing plots in a read operation for a Graphics Double Data Rate 7 (GDDR7) Synchronous Dynamic Random-Access Memory (SDRAM), where a read clock (RCK) is triggered by a READ command, in accordance with various embodiments.
FIG. 3 depicts an example clock path 300 including continuous time linear equalizer (CTLE) stages 310 and an AC-coupled buffer 350 with a feedback resistor Rf, in accordance with various embodiments.
FIG. 4 depicts example plots of a duty cycle recovery time in an AC-coupled buffer, in accordance with various embodiments.
FIG. 5 depicts example plots of a clock passing through the clock path 300 of FIG. 3, in accordance with various embodiments.
FIG. 6A depicts an example implementation of an AC-coupled buffer circuit 600 comprising a complementary metal-oxide semiconductor (CMOS) inverter 601 with a variable-impedance feedback circuit 610, in accordance with various embodiments.
FIG. 6B depicts a flowchart of a method consistent with the circuit 600 of FIG. 6A, in accordance with various embodiments.
FIG. 7A depicts a circuit 700 in an example implementation of the CMOS inverter 601 of FIG. 6A, where a feedback circuit 709 includes two diode-connected n-type transistors M2n and M3n coupled between the input node 602 and the output node 603, where a control gate of M3n is coupled to the input node 602, and a control gate of M2n is coupled to the output node 603, in accordance with various embodiments.
FIG. 7B depicts a circuit 710 in an example implementation of the CMOS inverter 601 of FIG. 6A, where a feedback circuit 711 includes two diode-connected p-type transistors M2p and M3p coupled between the input node 602 and the output node 603, where a control gate of M3p is coupled to the input node 602, and a control gate of M2p is coupled to the output node 603, in accordance with various embodiments.
FIG. 7C depicts a circuit 720 in an example implementation of the CMOS inverter 601 of FIG. 6A, where a feedback circuit 721 includes a diode-connected n-type transistor M3n and a diode-connected p-type transistor M2p coupled between the input node 602 and the output node 603, where control gates of Mn3 and M2p are coupled to each other and to the input node 602 via nodes 727 and 701, in accordance with various embodiments.
FIG. 7D depicts a circuit 730 in an example implementation of the CMOS inverter 601 of FIG. 6A, where a feedback circuit 731 includes a diode-connected n-type transistor M3n and a diode-connected p-type transistor M2p coupled between the input node 602 and the output node 603, where control gates of Mn3 and M2p are coupled to each other via a node 737 and to the output node 603 via a node 702, in accordance with various embodiments.
FIG. 7E1 depicts a circuit 740 in an example implementation of the CMOS inverter 601 of FIG. 6A, where a feedback circuit 741 includes first and second transmission gates 742 and 743, respectively, in accordance with various embodiments.

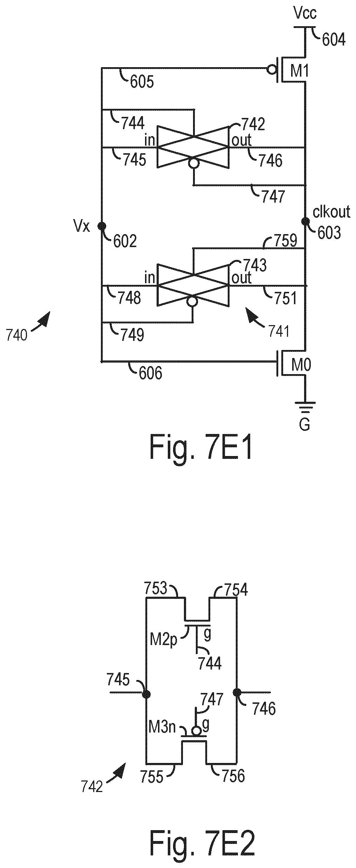

FIG. 7E2 depicts an example implementation of the first transmission gate 742 of FIG. 7E1, in accordance with various embodiments.

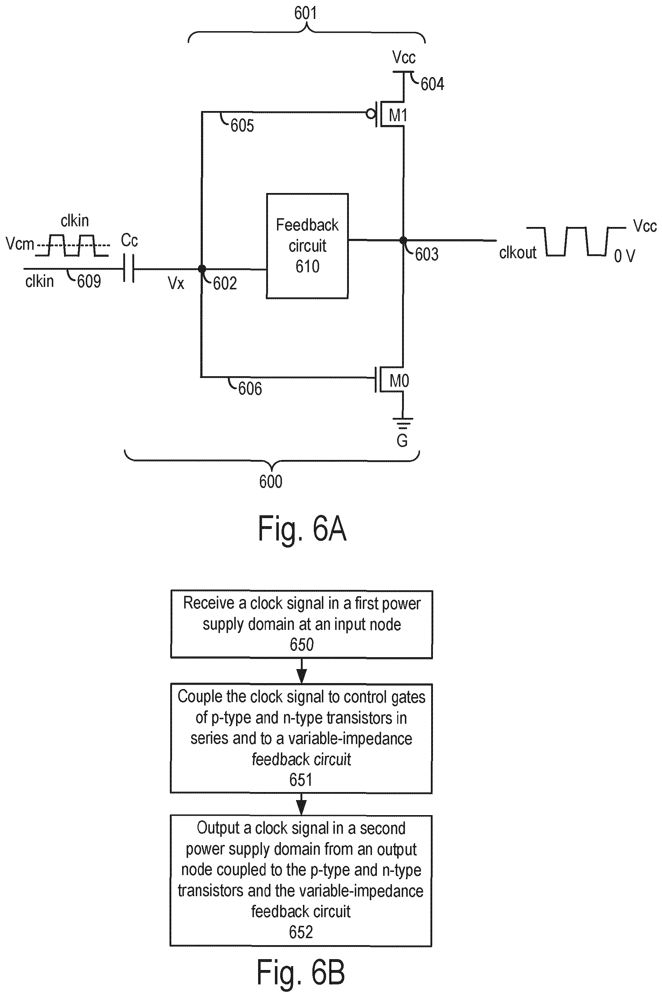

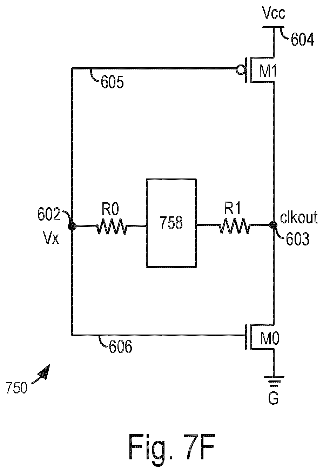

FIG. 7F depicts a circuit 750 in an example implementation of the CMOS inverter 601 of FIG. 6A, where a feedback circuit 758 is coupled to the input node 602 by a first resistor R0, and to the output node 603 by a second resistor R1, in accordance with various embodiments.

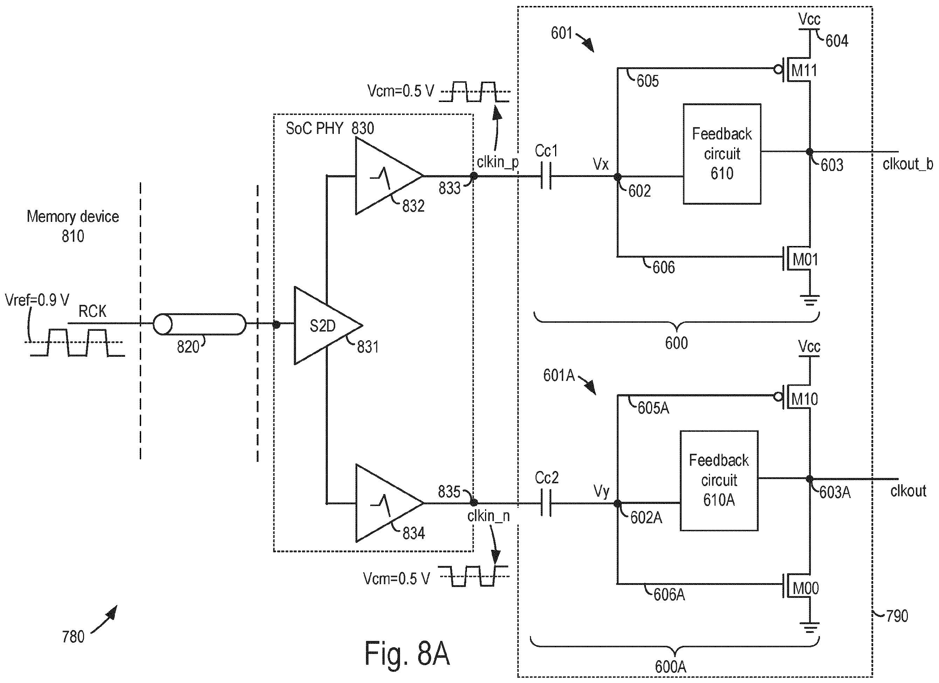

FIG. 8A depicts a fully differential clock path 780 which includes the AC-coupled buffer 600 of FIG. 6A and a corresponding AC-coupled buffer 600A for receiving complementary clock signals clkin_p and clkin_n, respectively, in accordance with various embodiments.

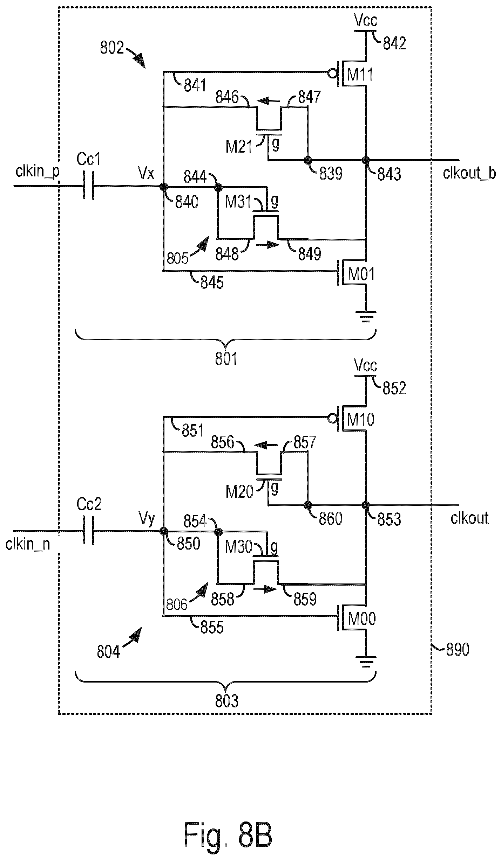

FIG. 8B depicts a circuit 890 in an example implementation of the circuit 790 of FIG. 8A, in accordance with various embodiments.

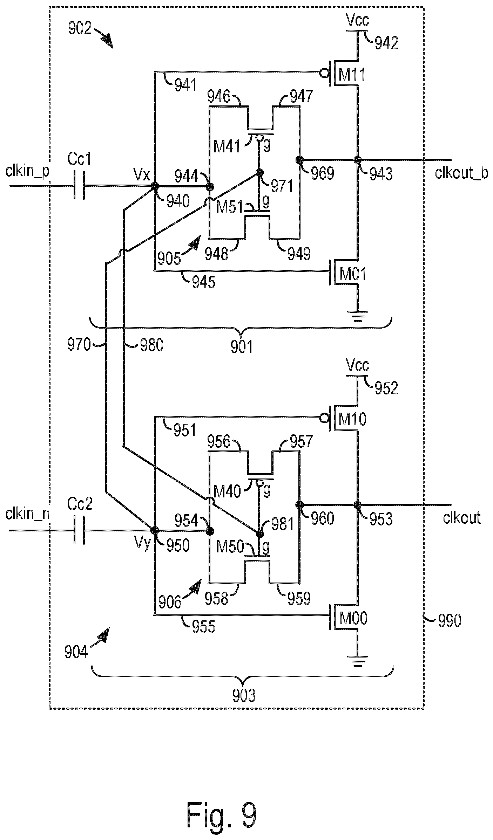

FIG. 9 depicts a circuit 990 in another example implementation of the circuit 790 of FIG. 8A, where cross-coupling paths 970 and 980 are provided at the inputs of CMOS inverters 902 and 904, in accordance with various embodiments.

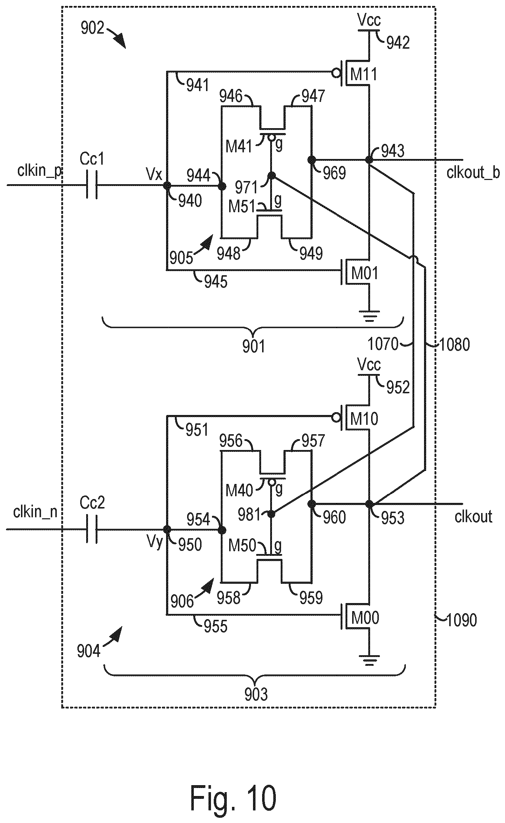

FIG. 10 depicts a circuit 1090 in which the circuit 990 of FIG. 9 is modified by providing cross-coupling paths 1070 and 1080 at the outputs instead of the inputs of the CMOS inverters 902 and 904, in accordance with various embodiments.

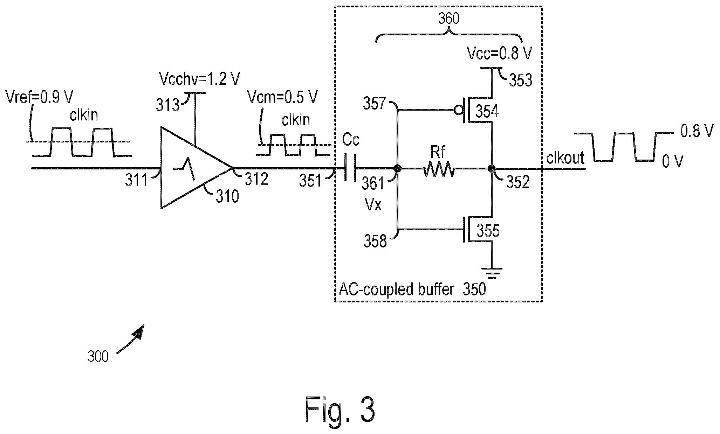

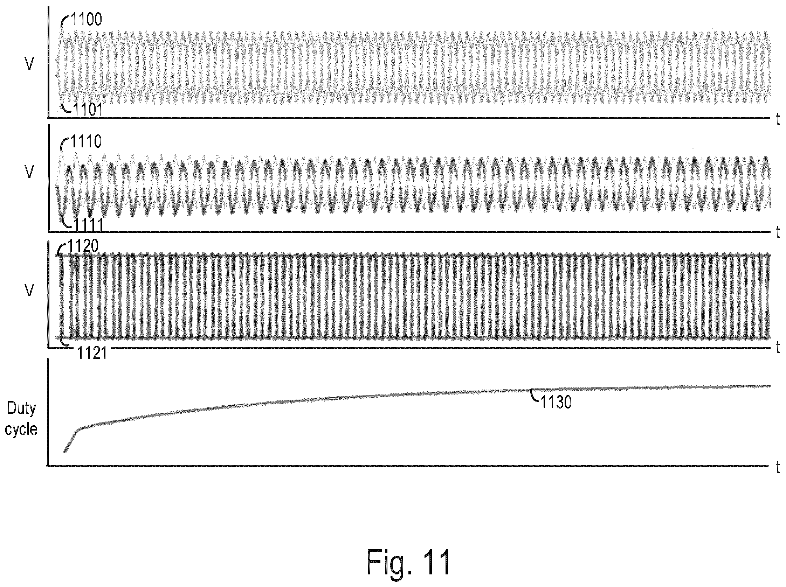

FIG. 11 depicts plots indicating the operation of a differential clock path based on the AC-coupled buffer 350 of FIG. 3, in accordance with various embodiments.

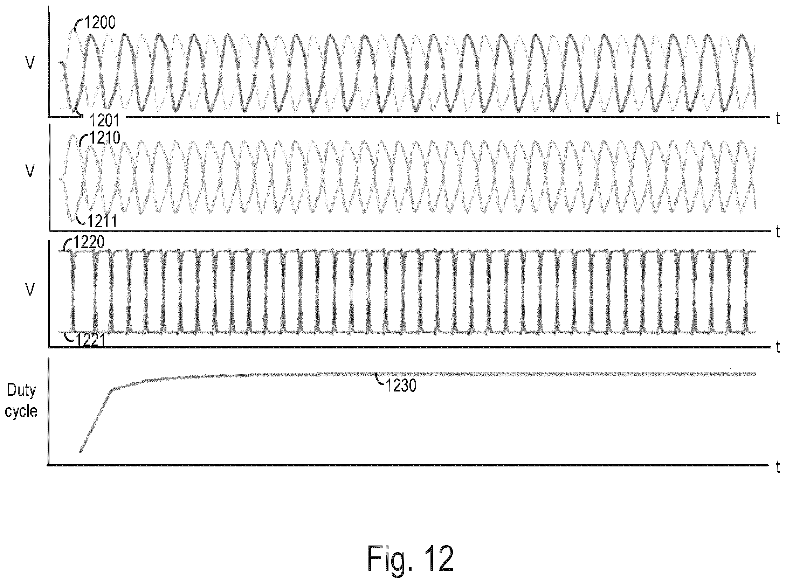

FIG. 12 depicts plots indicating the operation of the circuit 890 of FIG. 8B, in accordance with various embodiments.

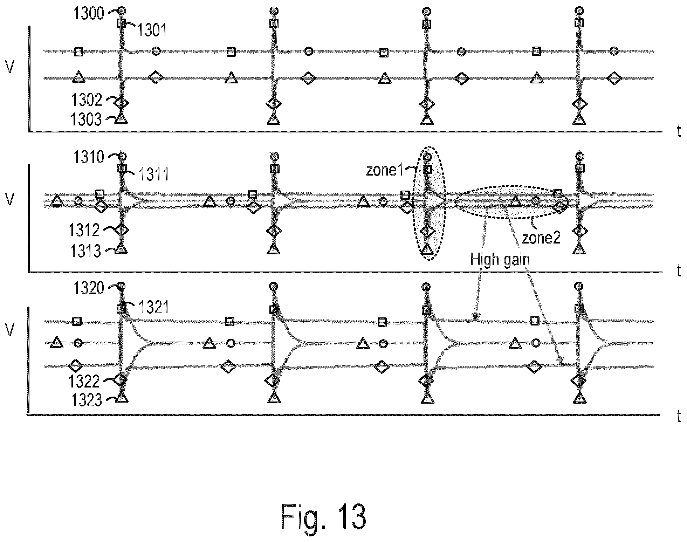

FIG. 13 depicts plots comparing the operation of the circuit 890 of FIG. 8B to a differential clock path based on the AC-coupled buffer 350 of FIG. 3, respectively, in accordance with various embodiments.

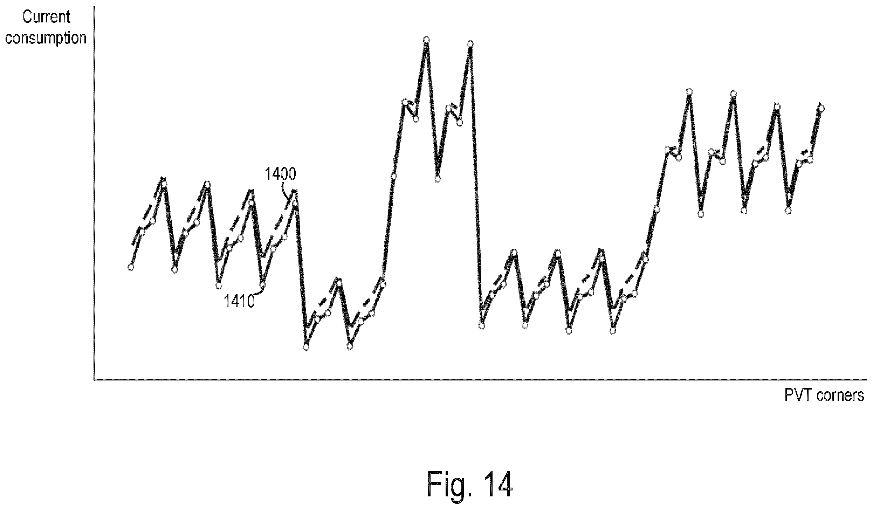

FIG. 14 depicts plots comparing a current consumption of the AC-coupled buffer 801 or 803 in FIG. 8B (plot 1400, dashed line) to a current consumption of the AC-coupled buffer 350 of FIG. 3 (plot 1410, solid line with circles), in accordance with various embodiments.

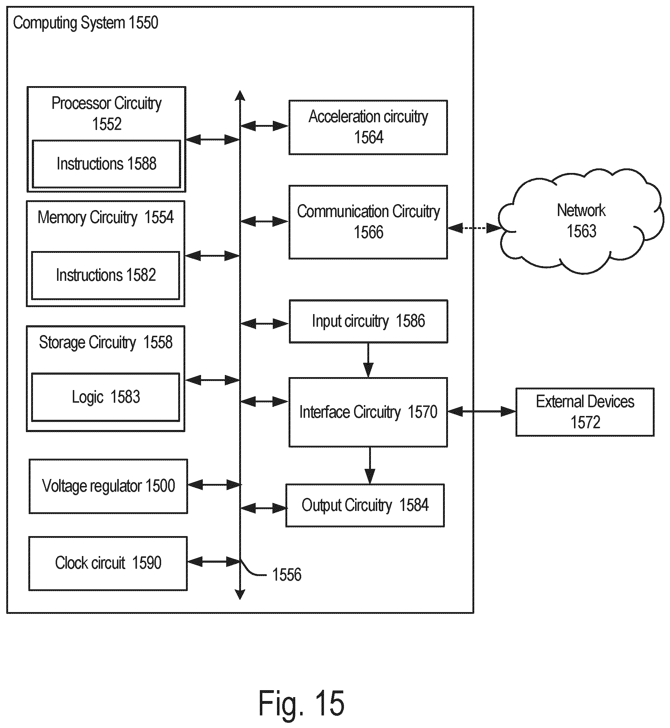

FIG. 15 illustrates an example of components that may be present in a computing system 1550 for implementing the techniques (e.g., operations, processes, methods, and methodologies) described herein.

### DETAILED DESCRIPTION

As mentioned at the outset, various challenges are presented in designing an AC-coupled buffer.

AC-coupled buffers are widely used in low power clocking applications to completely block the DC component of an incoming clock/signal and set an internal common mode with a self-biased inverter. This self-biasing also corrects the duty cycle to some extent. An AC-coupled buffer can include a capacitor followed by a complementary metal-oxide semiconductor (CMOS) inverter which includes a feedback resistor Rf between the input and output of the inverter. AC coupling with a resistive feedback-based inverter amplifier results in a band pass characteristic which improves the jitter and phase noise of the input clock.

In an example application, the clock is used in a memory device such as a Graphics Double Data Rate 7 (GDDR7) Synchronous Dynamic Random-Access Memory (SDRAM).

However, when the clock reaches the AC-coupled buffer, it disturbs the self-bias at the input and hence the duty cycle of the clock at the output is also disturbed. The duty cycle will take some time to recover, creating issues such as reducing the performance of data sampling using the clock, especially in a burst mode read operation.

One approach to improve the duty cycle recovery time is to use a low input impedance amplifier with a small resistor. However, with this approach, the cut off frequency will be quite high and lower frequencies will be heavily attenuated, so that there is a reduced ability to use a wide frequency range of clock signals.

The solutions provided herein address the above and other disadvantages. In one aspect, an AC-coupled buffer is provided which reduces a duty cycle recovery time of a clock signal to allow an extremely wide range of clock frequencies. The AC-coupled buffer may use a variable-impedance feedback element coupled between the input and output nodes of an inverter-based amplifier.

In an example implementation, the variable-impedance feedback element comprises first and second diode-connected transistors. The gates of the first and second transistors can be coupled to input and output nodes, respectively, of the AC-coupled buffer. Or, the gates of the first and second transistors can both be coupled to input node or both coupled to the output node of the AC-coupled buffer. In another example implementation, the variable-impedance feedback element comprises first and second transmission gates which are both coupled to the input and output nodes of the AC-coupled buffer.

The solutions provide a number of benefits, including increasing the burst mode performance of a read operation. The solutions significantly reduce the duty cycle settling time of a clock signal, e.g., by about 90%. The solutions achieve an ultra-wide band performance which allows the frequency of a clock signal to vary in a large range, e.g., from 200 MHz to 10 GHz. The solution also does not consume any extra power and reduces the area used on the integrated circuit by about 50%. These and other features will be further apparent in view of the following discussion.

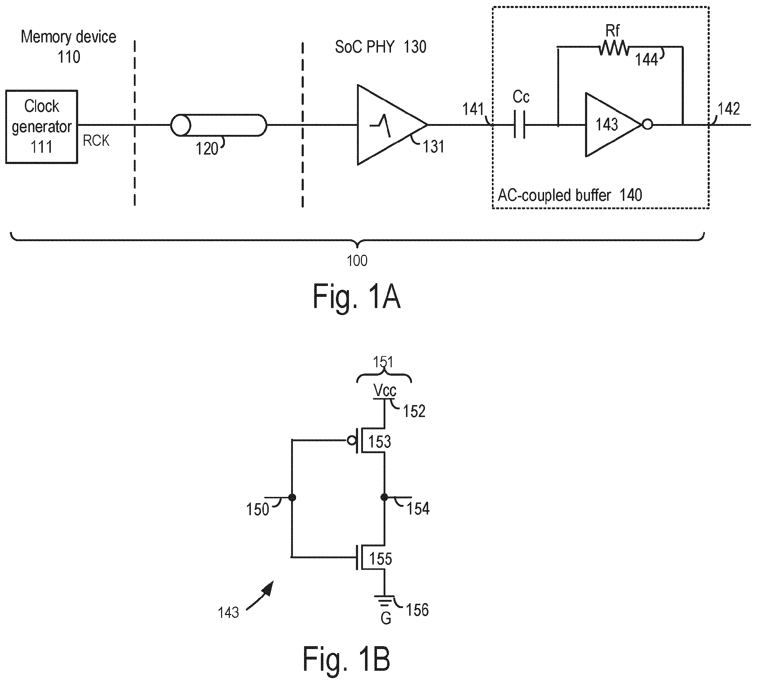

FIG. 1A depicts an example clock distribution network 100 or path including an alternating-current (AC) buffer 140 receiving a clock in one supply domain and converting it to another supply domain, in accordance with various embodiments. This clock can be a clock coming from the transmitter side as in the forward clock architectures for GDDR7. The data path includes a memory device 110 in which a clock generator 111 provides a read clock (RCK) signal. The clock generator can comprise an oscillator such as a crystal oscillator or a voltage-controlled-oscillator and other circuitry such as a frequency divider and/or a phase-locked loop. RCK is passed via a channel 120 to a physical layer (PHY) 130 of a System-On-Chip (SoC), for example, or other circuit. This physical layer can include one or more continuous-time linear equalizer (CTLE) stages 131 or any other driver circuitry on or off chip, e.g., on a same chip with the AC buffer or on a different chip than a chip having the AC buffer.

The CTLE compensates for signal distortion caused by frequency-dependent losses or other impairments in the channel by boosting or attenuating specific frequency components of the incoming clock signal.

The clock signal output from the CTLE stages is provided to an input node 141 of an AC-coupled buffer 140, which includes a coupling capacitor Cc, an inverter 143, a feedback path 144 including a feedback resistor Rf, and an output node 142.

FIG. 1B depicts an example implementation of the inverter 143 of FIG. 1A, in accordance with various embodiments. The AC-coupled buffer 140 includes an input node 150 and an output node 154 in a current path 151. The current path 151 includes, in series, a power supply node 152 at Vcc, a p-type transistor 153, the output node 154, an n-type transistor 155 and a ground (G) node 156. The transistors depicted herein and in other figures may be metal-oxide-semiconductor field-effect transistors (MOSFETs), for example (e.g., pMOSFET or nMOSFET).

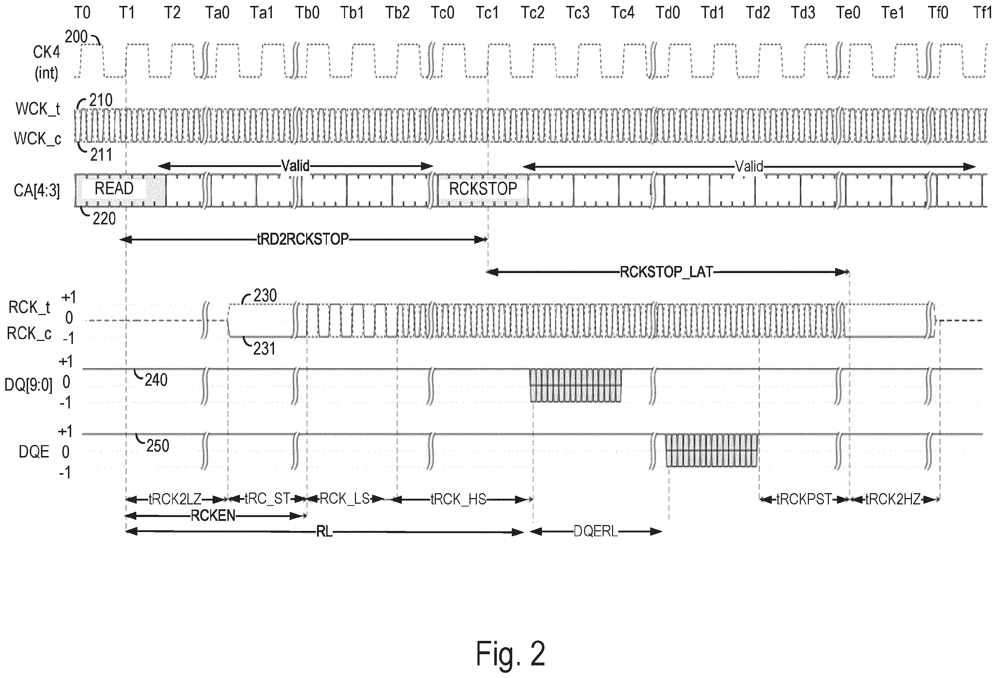

FIG. 2 depicts example read timing plots in a read operation for a Graphics Double Data Rate 7 (GDDR7) Synchronous Dynamic Random-Access Memory (SDRAM), where a read clock (RCK) is triggered by a READ command, in accordance with various embodiments. As mentioned, one example use of a clock signal is in reading a memory device. In this implementation, the clock signal is a read clock for a GDDR7 SDRAM. However, other types of memory devices could be used as well. The plots represent voltage in a vertical direction and time in a horizontal direction. The time includes groups of time points T0-T2, Ta0-Ta1, Tb0-Tb2, Tc1-Tc4, Td0-Td3, Te0-Te1 and Tf0-Tf1.

The figure describes a read path timing diagrams for GDDR7 where RCK is triggered with a READ command. RCK starts toggling as a function of the READ command. RCK travels from one power supply domain to another power supply domain and while minimizing the overall power, there is a fast-settling requirement of maintaining the RCK duty cycle within ±1%.
CK4 (plot 200) is an internal divide-by-four clock that is used as a reference.
WCK_t (plot 210) is the write clock, transition or differential component. WCK_c (plot 211) is the write clock, common mode component. The write clock is responsible for timing and synchronizing the writing of data into the memory cells
CA[4:3] (plot 220) is a column address in Bank Y for issuing a read command, where Banks X and Y are two banks or sections of the memory. Generally, GDDR7 memory subsystems can issue two independent commands in parallel. For example, Bank X can be refreshed by issuing a Refresh per bank command on CA[2:0], while Bank Y can be read by issuing a read command on CA[4:3] at the same time.

Time periods of interest include tRD2RCKSTOP (time from READ to RCKSTOP) and RCKSTOP_LAT. The read clock stop (RCKSTOP) signal is used to stop the operation of the read clock (RCK), preventing further read operations from occurring. RCKSTOP_LAT refers to the latency associated with activating or deactivating RCKSTOP.

RCK_t (plot 230) and RCK_c (plot 231) are true and complementary clocks, respectively, with a phase difference of 180 degrees. The read clock signal is responsible for timing and synchronizing the reading of data from the memory cells.

DQ[9:0] (plot 240) represents a range of ten data queues or data lines used for bidirectional data transfer between the memory device and the memory controller or other components of the system. These data lines carry the actual data being read from or written to the memory cells.

DQE (plot 250) is the data pin which is used to receive the error signal sent by the memory to the host.

Time periods of interest include tRCK2LZ, tRC_ST, RCK_LS, tRCK_HS, tRCKPST, tRCK2HZ, RCKEN, RL and DQERL consistent with the GDDR7 JEDEC specification. For example, tRCK2LZ is a read clock in highZ state time, tRC_ST is a read clock static preamble time, tRCK_LS is a read clock low speed preamble time, and tRCK_HS is a read clock high speed preamble time.

DQERL refers to the DQE Read Latency, e.g., the latency associated with reading data from an empty data queue.

FIG. 3 depicts an example clock path 300 including continuous time linear equalizer (CTLE) stages 310 and an AC-coupled buffer 350 with a feedback resistor Rf, in accordance with various embodiments. In an example implementation, the clock path is in a memory device. The CTLE stages 310 have an input node 311 which receives the input clock, clkin, having a reference voltage Vref=0.9 V, for example. The CTLE stages operate in a power domain based on a power supply node 313 at a relatively high voltage (hv) of Vcchv=1.2 V, for example. Clkin is provided with a common mode voltage Vcm=0.5 V, for example, at the output node 312 of the CTLE stages. This clock is received at the input node 351 of the AC-coupled buffer 350.

The AC-coupled buffer includes the coupling capacitor Cc and a CMOS inverter 360. The CMOS inverter 360 includes an input node 361 at a voltage Vx, an output node 352 at a voltage clkout, a first path 357 to couple the input node 361 to the gate of a p-type transistor 354, and a second path 358 to couple the input node 361 to the gate of an n-type transistor 355. The feedback resistor Rf is coupled between the input and output nodes. The source of the p-type transistor 354 is coupled to a power supply node 353 at a relatively low voltage such as Vcc=0.8 V. The CTLE stages and the AC-coupled buffer thus operate in first and second power domains, respectively, where a power supply voltage is lower in the second power domain compared to the first power domain.

The output clock, clkout, at the output node 352 oscillates between Vcc=0.8 V and ground. Additionally, clkout is inverted relative to clkin. In particular, when clkin is low, the transistor 354 is on and the transistor 355 is off so that the output node 352 is coupled to the power supply node 353. When clkin is high, the transistor 354 is off and the transistor 355 is on so that the output node 352 is coupled to the ground.

The AC-coupled buffer can receive the clock from a GDDR memory through a read channel. As mentioned, the clock first reaches the CTLE stages in a 1.2 V supply domain and is then converted to low voltage supply domain which is nominally 0.8 V in this example. The CTLE output is at 0.5 V common mode. The CTLE output clock reaches the AC-coupled buffer and gets converted to the low voltage (e.g., 0.8 V) supply domain with almost 50% duty cycle due to its self-biasing. To optimize the area of the AC-coupled buffer and to keep the cut-off frequency low, Rf can be chosen to be, e.g., 10 K, while Cc is chosen to be, e.g., 250 fF, for example, in a current GDDR7 receiver (RX) chain. The cut-off frequency of this AC-coupled buffer is ~65 MHz so that it passes a minimum 1 GHz clock frequency without much attenuation. The maximum clock frequency which has to pass through this AC-coupled buffer is 10 GHz.

Before arrival of the clkin at the input node 351, node Vx settles to the resistive feedback amplifier's self-bias voltage. When the clock reaches the AC-coupled buffer, it disturbs the self-bias voltage at Vx and hence the duty cycle of the clock at the output node 352. Note that the CMOS inverter 360 acts as an amplifier by providing clkout in a higher power domain than clkin.

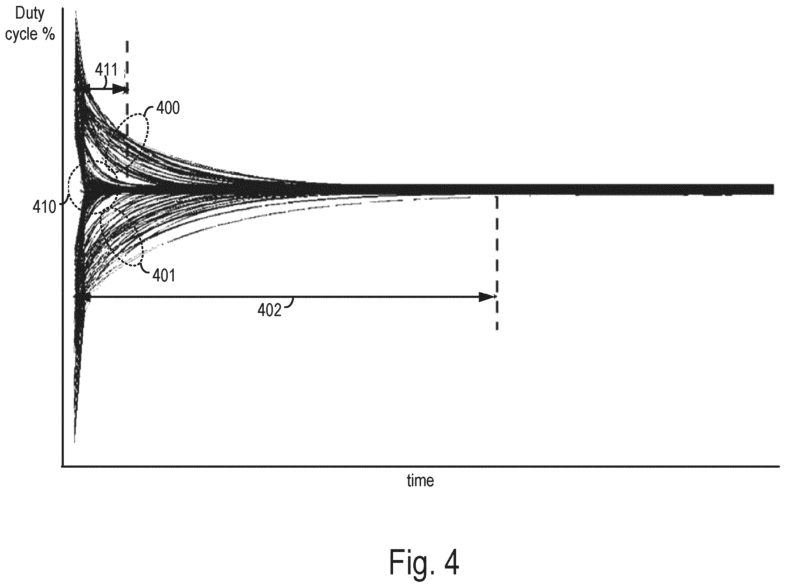

The disturbed self-bias voltage takes some time to settle to its original value. Since this self-bias disturbance also disturbs the duty cycle of the output clock, the duty cycle recovery will also take a similar amount of time. In particular, the self-bias voltage and the duty cycle recovery time depends on the value: Rf*Cc. A large resistor value is also required for high gain, but with a large resistor it may take several nanoseconds, for instance, to recover its self-bias voltage and hence the duty cycle of the output clock settles in several nanoseconds, for instance, such as shown in FIG. 4 (plots 400 and 401).

FIG. 4 depicts example plots of a duty cycle recovery time in an AC-coupled buffer, in accordance with various embodiments. The vertical axis depicts duty cycle in % and the horizontal axis depicts time. The plots represent the duty cycle settling or recovery time through an AC-coupled buffer at 10 GHz clock frequency. In particular, plots 400 and 401 represent the duty cycle and the arrow 402 represents a relatively long duty cycle recovery time with the AC-coupled buffer 350 of FIG. 3. Plot 410 represents the duty cycle and the arrow 411 represents a much shorter duty cycle recovery time with the AC-coupled buffers which have a variable-impedance feedback circuit such as discussed below in FIGs 6-10. The plots show that the duty cycle settling time of a clock signal can be reduced significantly, e.g., by about 90%.

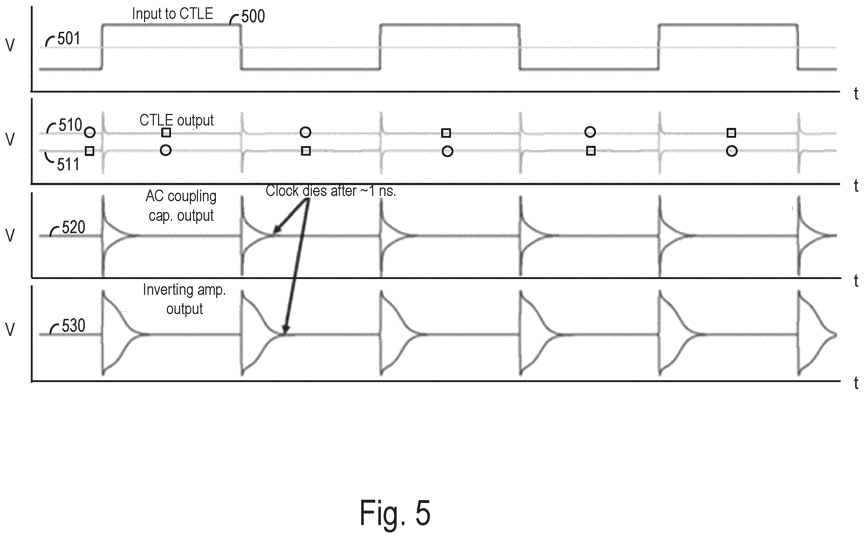

One approach to improve the duty cycle recovery time is to use a low input impedance amplifier with a small feedback resistor (Rf). However, the gain of the amplifier will be reduced when the resistor is smaller. The cut off frequency will be quite high and lower frequencies will be heavily attenuated and eventually the clock will die at lower frequencies as shown in FIG. 5. For many applications, a wider frequency range is required (e.g., MHz to GHz). On the other hand, a large resistor can be used to achieve a wide frequency range and a high gain amplifier but at the cost of a large duty cycle recovery/settling time. The resulting disturbance in clock duty cycle will last for several nanoseconds, for instance, and will create issues in data sampling at very high clock frequencies (e.g., 10 GHz) in the burst mode of DDR SDRAM and specifically in GDDR7 memory where the burst length is several bytes.

An AC-coupled buffer which has a variable-impedance feedback circuit such as discussed below in FIGs 6-10 improves duty cycle recovery time while avoiding the above-mentioned disadvantages.

FIG. 5 depicts example plots of a clock passing through the clock path 300 of FIG. 3, in accordance with various embodiments. Plot 500 depicts the input clock to the CTLE 310 and plot 501 depicts Vref=0.9 V, for example. Plot 510 depicts the output of the CTLE which oscillates above and below Vcm=0.5 V, for example, and plot 511 depicts a signal which is antiphase or complementary to the plot 510. For example, this applies when a differential clock is used (see, e.g., FIG. 8A).

Plot 520 depicts the output of the AC coupling capacitor Cc at the node 361 and plot 530 depicts the output of the inverting amplifier at the node 352. The clock passes through the AC-coupled buffer at a 100 MHz clock frequency. The arrows indicate that the clock signal dies after about 1 ns in this example.

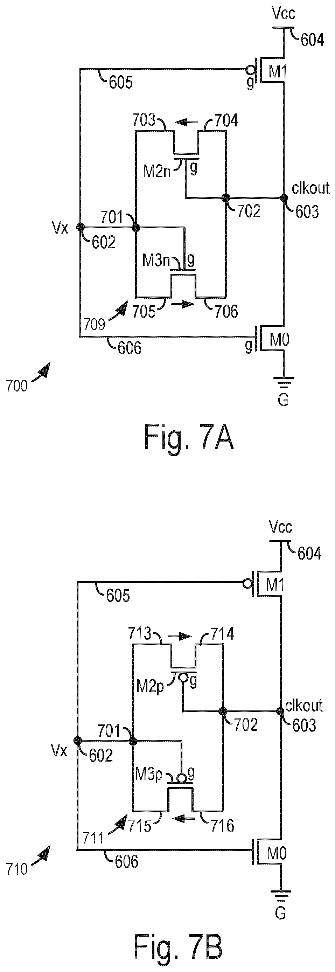

FIG. 6A depicts an example implementation of an AC-coupled buffer circuit 600 comprising a complementary metal-oxide semiconductor (CMOS) inverter 601 with a variable-impedance feedback circuit 610, in accordance with various embodiments. Clkin is provided on a path 609 to the input node 602 (at a voltage Vx) via Cc. Vx at the input node 602 is provided on a first path 605 to the gate of a p-type transistor M1, and on a second path 606 to the gate of an n-type transistor M0. The feedback circuit 610 is coupled between the input and output nodes 602 and 603, respectively. The feedback circuit can have a number of configurations such as depicted in FIGs. 7A-10. The output node 603 provides clkout as an inverse of Vx but at different voltage levels.

The feedback circuit provides an AC-coupled buffer which significantly improves the duty cycle recovery time. For example, the recovery time can be reduced from several nanoseconds (~6ns) to a few hundred picoseconds (~500ps or 0.5ns) to reach within +/- 1% duty cycle distortion. With this technique, an extremely wide range of clock frequency (e.g., a few hundred MHz to tens of GHz) can be easily achieved while with the circuit of FIG. 3 it is difficult to achieve a 1 GHz or lower clock frequency. The solution of FIG. 6A uses a variable-impedance feedback element for an inverter-based amplifier instead of a fixed-impedance resistor Rf.

The solution can enhance the burst mode performance of memory circuits such as GDDR7 circuits at 32 Gbps with a large margin. In GDDR7, the burst length is multiple bytes and its performance is mainly limited by the duty cycle recovery time. Moreover, the duty cycle recovery time can be significantly improved without any penalty in power and area.

Example implementations of an ultra-wide band AC-coupled buffer circuit are provided in FIGs. 7A-10. In the implementations of FIGs. 7A-7D and 7F, the resistor Rf of FIG. 3 is replaced with transistors M2 and M3. In the implementation of FIG. 7E, the resistor Rf of FIG. 3 is replaced with transmission gates which each include transistors M2 and M3.

FIG. 6B depicts a flowchart of a method consistent with the circuit 600 of FIG. 6A, in accordance with various embodiments. An operation 650 includes receiving a clock signal, e.g., clkin, in a first power supply domain at an input node 602. An operation 651 includes coupling the clock signal to control gates of p-type and n-type transistors (M1 and M0, respectively) in series and to a variable-impedance feedback circuit 610. An operation 652 includes outputting a clock signal in a second power supply domain from an output node 603 coupled to the p-type and n-type transistors and the variable-impedance feedback circuit.

One possible implementation includes an apparatus comprising means to perform the method. Another possible implementation includes a machine-readable storage including machine-readable instructions which, when executed, cause a computer to implement the method. Another possible implementation includes a computer program comprising instructions which, when executed by a computer, cause the computer to carry out the method.

FIG. 7A depicts a circuit 700 in an example implementation of the CMOS inverter 601 of FIG. 6A, where a feedback circuit 709 includes two diode-connected n-type transistors M2n and M3n coupled between the input node 602 and the output node 603, where a control gate of M3n is coupled to the input node 602, and a control gate of M2n is coupled to the output node 603, in accordance with various embodiments. The circuit includes a power supply node 604 at Vcc, a p-type transistor M1, the output node 603, an n-type transistor M0 and a ground node (G). The p-type transistor has a source coupled to the power supply node 604, a drain coupled to the output node 603, and a control gate g coupled to the input node 602 by a first path 605. The n-type transistor has a source coupled to the ground node G, a drain coupled to the output node 603, and a control gate g coupled to the input node 602 by a second path 606.

A diode-connected MOSFET has its gate coupled to its drain. An nMOSFET only allows current to flow from the drain to the source if the drain potential is higher than the source potential. A pMOSFET only allows current to flow from the source to the drain if the source potential is higher than the drain potential. The arrows adjacent to the diode-connected transistors show the direction of current flow in FIGs. 7A-7D and 8B. A diode-connected transistor is a diode which allows current to flow in one direction only, e.g., from the input node to the output node such as in the case of the diode-connected transistor M3n, or from the output node to the input node such as in the case of the diode-connected transistor M2n.

In the feedback circuit 709, M2n has a gate g coupled to a node 702 which in turn is coupled to the output node 603, a source terminal 703 coupled to a node 701, which in turn is coupled to the input node 602, and a drain terminal 704 coupled to the node 702.

M3n has a gate g coupled to the node 701, a drain terminal 705 coupled to the node 701, and a source terminal 706 coupled to the node 702.

In FIGs. 7A-7E1 and 7F, the n-type transistor M0 and p-type transistor M1 implement a CMOS inverter. Vx and clkout are an input and output, respectively, of the inverter. One of the terminals of capacitor Cc is connected to an incoming AC signal (clkin) and the other terminal is coupled to Vx which is input of the inverter.

In this example, M2n and M3n are n-type transistors. Gate and drain terminals of transistors M2n and M3n are coupled to the nodes at clkout and Vx, respectively. Source terminals of M2n and M3n are coupled to Vx and clkout, respectively.

In summary, M2 and M3 are connected in a diode-connected implementation between an input (Vx) and output (clkout) of the inverter. One end of the AC coupling capacitor Cc is coupled to the incoming AC signal and other end of the capacitor Cc is coupled to the input of the inverter Vx where M2 and M3 are connected as shown. Generally, one or the other, but not both, of the two transistors will pass a signal at a given time, in FIGs. 7A-7D. That is, the feedback circuit can include a first transistor to pass current from the input to the output node, and a second transistor to pass current from the output to the input node. Advantageously, the diode-connected transistors M2 and M3 have a very low impedance when a clock edge of clkin (positive or negative) passes through the capacitor Cc. Initially, the voltage difference between Vx and clkout is quite high, which results in a low impedance. This low input impedance of the inverting amplifier does not allow any unwanted DC (self-bias) voltage shift. Slowly, the voltage at Vx tries to settle to the inverting amplifier's self-bias voltage, and the potential difference across these diodes reduces. This increases the impedance, giving a very high gain at lower frequencies.

Therefore, this solution can work in a wide range of frequencies, from very high frequencies to extremely low frequencies, resulting in an ultra-wide band AC-coupled buffer.

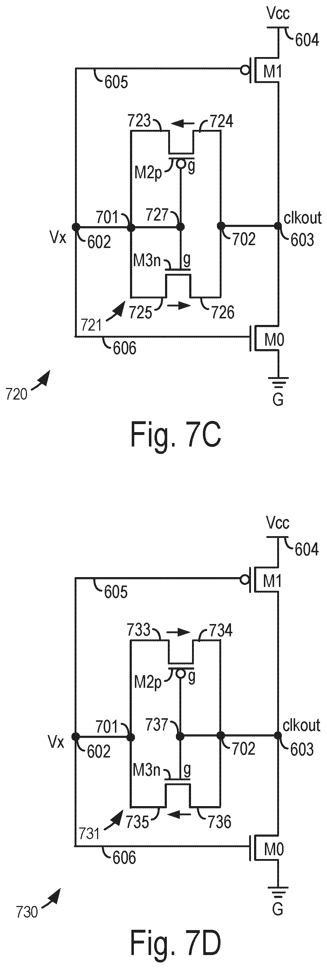

The M2 and M3 transistors can be both nMOSFETs such as in FIG. 7A, both pMOSFETs such as in FIG. 7B, or a combination of nMOSFET and pMOSFET, such as in FIGs. 7C and 7D, and can also be connected in alternative ways as depicted herein.

FIG. 7B depicts a circuit 710 in an example implementation of the CMOS inverter 601 of FIG. 6A, where a feedback circuit 711 includes two diode-connected p-type transistors M2p and M3p coupled between the input node 602 and the output node 603, where a control gate of M3p is coupled to the node 701, and a control gate of M2p is coupled to the node 702, in accordance with various embodiments.

M2p has a gate g coupled to the node 702, a source terminal 713 coupled to the node 701, and a drain terminal 714 coupled to the node 702. M2p allows current to flow from the input node to the output node.

M3p has a gate g coupled to the node 701, a source terminal 716 coupled to the node 702, and a drain terminal 715 coupled to the node 701. M3p allows current to flow from the output node to the input node.

In this implementation, M2p and M3p are p-type transistors. Gate and drain terminals of M2p are coupled to clkout and the source terminal of M2p is coupled to Vx. Gate and drain terminals of M3p are coupled to Vx and the source terminal of M3p is coupled to clkout.

FIG. 7C depicts a circuit 720 in an example implementation of the CMOS inverter 601 of FIG. 6A, where a feedback circuit 721 includes a diode-connected n-type transistor M3n and a diode-connected p-type transistor M2p coupled between the input node 602 and the output node 603, where control gates of Mn3 and M2p are coupled to each other and to the input node 602 via nodes 727 and 701, in accordance with various embodiments.

M2p has a gate g coupled to the node 727, a drain terminal 723 coupled to the node 701, and a source terminal 724 coupled to the node 702. M2p allows current to flow from the output node to the input node.

M3n has a gate g coupled to the node 727, a drain terminal 725 coupled to the node 701, and a source terminal 726 coupled to the node 702. M3n allows current to flow from the input node to the output node.

FIG. 7D depicts a circuit 730 in an example implementation of the CMOS inverter 601 of FIG. 6A, where a feedback circuit 731 includes a diode-connected n-type transistor M3n and a diode-connected p-type transistor M2p coupled between the input node 602 and the output node 603, where control gates of Mn3 and M2p are coupled to each other via a node 737 and to the output node 603 via a node 702, in accordance with various embodiments.

M2p has a gate g coupled to the node 737, a source terminal 733 coupled to the input node 602 via a node 701, and a drain terminal 734 coupled to the output node 603 via the node 702. M2p allows current to flow from the input node to the output node.

M3n has a gate g coupled to the node 737, a source terminal 735 coupled to the node 701, and a drain terminal 736 coupled to the node 702. M3n allows current to flow from the output node to the input node.

FIG. 7E1 depicts a circuit 740 in an example implementation of the CMOS inverter 601 of FIG. 6A, where a feedback circuit 741 includes first and second transmission 742 and 743 gates, respectively, in accordance with various embodiments.

A transmission gate, or analog switch, is a solid-state circuit that can selectively block or pass a signal from the input to the output. This circuit is comprised of a pMOSFET transistor and nMOSFET transistor, for example, where the control gates are biased in a complementary manner so that both transistors are either on or off.

The transmission gate 742 has a signal input 745 (a first input/output node) and a control input 744 coupled to the input node 602 at Vx, and a signal output 746 (a second input/output node) and an inverse control input 747 coupled to the output node 603 at a voltage clkout. The signal input and output labels can be reversed since a transmission gate is bidirectional. The control input 744 is active high and the inverse control input 747 is active low. When the voltage on the control input 744 is a Logic 1 (high), the complementary Logic 0 (low) is applied to the inverse control input 747, allowing both transistors of the transmission gate 742 (see FIG. 7E2) to conduct and pass a signal between the signal input 745 and the signal output 746. When the voltage on the control input 744 is a Logic 0, Logic 1 is applied to the inverse control input 747, turning both transistors off and forcing a high-impedance condition on both the signal input and output 745 and 746, respectively.

Similarly, the transmission gate 743 has a signal input 748 and an inverse control input 749 coupled to the input node 602 at Vx, and a signal output 751 and a control input 759 coupled to the output node 603 at clkout. When the voltage on the inverse control input 749 is a Logic 0 (low), the complementary Logic 1 (high) is applied to the control input 759, allowing both transistors of the transmission gate 743 to conduct and pass the signal at the signal input 748 to the signal output 751. When the voltage on the inverse control input 749 is a Logic 0 (low), Logic 1 (high) is applied to the control input 759, turning both transistors off and forcing a high-impedance condition on both the input and output nodes.

Generally, one or the other, but not both, of the two transmission gates will pass a signal at a given time.

In this implementation, the resistor Rf of FIG. 3 is replaced with CMOS transmission gates arranged so that the control input (Vx) of the first transmission gate 742 is the inverse of the control input (clkout) of the second transmission gate.

FIG. 7E2 depicts an example implementation of the first transmission gate 742 of FIG. 7E1, in accordance with various embodiments. The second transmission gate can be configured similarly. The first transmission gate 742 includes M2p and M3n. M2p has a first source/drain terminal 753 coupled to the input 745, a second source/drain terminal 754 coupled to the output 746, and a gate g coupled to the control input 744. M3n has a first source/drain terminal 755 coupled to the input 745, a second source/drain terminal 756 coupled to the output 746, and a gate g coupled to the inverse control input 747. A source/drain terminal can act as a source or drain depending on the biasing of the transistor.

FIG. 7F depicts a circuit 750 in an example implementation of the CMOS inverter 601 of FIG. 6A, where a feedback circuit 758 is coupled to the input node 602 by a first resistor R0, and to the output node 603 by a second resistor R1, in accordance with various embodiments. R0 and R1 can be equal in one possible implementation. The feedback circuit 758 can include the transistors M2 and M3 such as in FIGs. 7A-7D or the transmission gates 742 and 743 such as in FIG. 7E1, connected through known resistors R0 and R1 to the input 602 and output 603, respectively. These resistors can also be implemented with the help of transistors. For example, a diode-connected variable impedance can be connected to the input and output of an inverter through any possible implementation of resistors. Another example is a polysilicon resistor.

The circuits of FIGs. 7A-7F depicts a single clock signal. However, a differential clock is used in many applications. A differential clock involves differential signaling, where data is transmitted as the difference in voltage between the signals on two wires rather than a single wire with respect to a common ground. This technique can be used, e.g., in high-speed data transmission to improve noise immunity and reduce signal degradation over longer distances. A differential clock includes two complementary clock signals, clkin_n (negative clock signal) and clkin_p (positive clock signal) that have opposite voltage polarities.

In an example implementation, the complementary clock signals pass through respective AC-coupled buffers such as depicted in FIGs. 8A-10.

The resistors R0 and R1 can be used to limit the lower limit of the impedance during transition. This will maintain a required minimum gain and also limit the high pass filter cut-off during transition. Another advantage of the resistors is protecting the diode-based variable impedance.

FIG. 8A depicts a fully differential clock path 780 which includes the AC-coupled buffer 600 of FIG. 6A and a corresponding AC-coupled buffer 600A for receiving complementary clock signals clkin_p and clkin_n, respectively, in accordance with various embodiments. The AC-coupled buffers 600 and 600A are first and second AC-coupled buffers, respectively.

RCK represent the read clock generated by a clock generator in a memory device 810. RCK is provided in a channel 820 to a physical layer (PHY) 830 of a System-On-Chip (SoC), for example. The PHY includes a signal-to-differential (S2D) conversion circuit 831 which outputs the differential components clkin_p and clkin_n, e.g., complementary clock signals.

A S2D conversion circuit is used to convert a single-ended input signal into a differential output signal. The conversion circuit can include an input stage which receives the single-ended input signal. This stage can include impedance matching and signal conditioning components to ensure proper signal integrity and compatibility with the subsequent circuitry. The input signal is then converted into a differential signal by a conversion stage of the circuit. This stage can include a differential amplifier or a pair of amplifiers configured in a differential configuration. The differential amplifier amplifies the voltage difference between two input terminals, creating a differential output signal. The output of the conversion stage is a pair of signals that are equal in magnitude but opposite in polarity, forming a differential signal pair. One signal represents the original input signal, while the other represents the inverse of the input signal. These signals are referred to as the positive (P) and negative (N) outputs of the differential signal pair, e.g., clkin_p and clkin_n, respectively.

clkin_p is provided to one or more CTLE stages 832 to provide a corresponding compensated value at output node 833, e.g., with Vcm=0.5 V. clkin_n is provided to one or more CTLE stages 834 to provide a corresponding compensated value at output node 835, e.g., with Vcm=0.5 V but opposite in polarity to clkin_p.

The compensated values of clkin_p and clkin_n are received at the AC-coupled buffers 600 and 600A, respectively, in the circuit 790. The AC-coupled buffer 600 includes a coupling capacitor Cc1 and the CMOS inverter 601. The CMOS inverter 601 includes the input node 602 at the voltage Vx, the output node 603 at the voltage clkout_b, the first path 605 to couple the input node 602 to the gate of a p-type transistor M11, the second path 606 to couple the input node 602 to the gate of an n-type transistor M01, and the feedback circuit 610.

The CMOS inverter 601 further includes, in series, the power supply node 604 at Vcc, M11, the output node 603, M01 and a ground node. M11 has a source coupled to the power supply node 604 and a drain coupled to the output node 603. M01 has a source coupled to the ground node and a drain coupled to the output node 603.

The AC-coupled buffer 600A is configured similarly to the AC-coupled buffer 600A, and includes a coupling capacitor Cc2 and a CMOS inverter 601A, which is configured similarly to the CMOS inverter 601 in this example. The CMOS inverter 601A includes an input node 602A at a voltage Vy, an output node 603 at a voltage clkout, a first path 605A to couple the input node 602A to the gate of a p-type transistor M10, a second path 606A to couple the input node 602A to the gate of an n-type transistor M00, and a feedback circuit 610A which may be configured similarly as the feedback circuit 610. The feedback circuits 610 and 610A can be any of the feedback circuits shown in FIGs. 7A-7F, for instance.

The CMOS inverters 601 and 601A are first and second CMOS inverters, respectively.

The CMOS inverter 601A further includes, in series, a power supply node at Vcc, M10, the output node 603A, M00 and a ground node. M10 has a source coupled to the power supply node and a drain coupled to the output node 603A. M00 has a source coupled to the ground node and a drain coupled to the output node 603A.

FIG. 8B depicts a circuit 890 in an example implementation of the circuit 790 of FIG. 8A, in accordance with various embodiments. First and second AC-coupled buffers 801 and 803, respectively, have first and second CMOS inverters 802 and 804, respectively, for receiving complementary clock signals clkin_p and clkin_n, respectively.

The compensated values of clkin_p and clkin_n are received at the AC-coupled buffers 801 and 803, respectively. The AC-coupled buffer 801 includes a coupling capacitor Cc1 and the CMOS inverter 802. The CMOS inverter is configured similarly to the circuit 700 of FIG. 7A in this example. The CMOS inverter 802 includes an input node 840 at a voltage Vx, an output node 843 at a voltage clkout_b, a first path 841 to couple the input node 840 to the gate of a p-type transistor M11, a second path 845 to couple the input node 840 to the gate of an n-type transistor M01, and a feedback circuit 805.

The CMOS inverter 802 further includes, in series, a power supply node 842 at Vcc, M11, the output node 843, M01 and a ground node. M11 has a source coupled to the power supply node 842 and a drain coupled to the output node 843. M01 has a source coupled to the ground node and a drain coupled to the output node 843.

The feedback circuit 805 includes first and second n-type diode-connected transistors M21 and M31, respectively. M21 has a gate g coupled to a node 839 which in turn is coupled to the output node 843, a drain terminal 847 coupled to the node 839, and a source terminal 846 coupled to the input node 840. M31 has a gate g coupled to a node 844 which in turn is coupled to the input node 840, a drain terminal 848 coupled to the node 844, and a source terminal 849 coupled to the output node 843.

The AC-coupled buffer 803 can be configured similarly to the AC-coupled buffer 801. The AC-coupled buffer 803 includes a coupling capacitor Cc2 and a CMOS inverter 804. The CMOS inverter 804 can be configured similarly to the CMOS inverter 802. The CMOS inverter 804 includes an input node 850 at a voltage Vy, an output node 853 at a voltage clkout, a first path 851 to couple the input node 850 to the gate of a p-type transistor M10, a second path 855 to couple the input node 850 to the gate of an n-type transistor M00, and a feedback circuit 806.

The CMOS inverter 804 further includes, in series, a power supply node 852 at Vcc, M10, the output node 853, M00 and a ground node. M10 has a source coupled to the power supply node 852 and a drain coupled to the output node 853. M00 has a source coupled to the ground node and a drain coupled to the output node 853.

The feedback circuit 806 can be configured similarly to the feedback circuit 805. The feedback circuit 806 includes first and second n-type diode-connected transistors M20 and M30, respectively. M20 has a gate g coupled to a node 860which in turn is coupled to the output node 853, a drain terminal 857 coupled to the node 860, and a source terminal 856 coupled to the input node 850. M30 has a gate g coupled to a node 854 which in turn is coupled to the input node 850, a drain terminal 858 coupled to the node 854, and a source terminal 859 coupled to the output node 853.

FIG. 9 depicts a circuit 990 in another example implementation of the circuit 790 of FIG. 8A, where cross-coupling paths 970 and 980 are provided at the inputs of CMOS inverters 902 and 904, in accordance with various embodiments. The circuit 990 includes first and second AC-coupled buffers 901 and 903, respectively, having first and second CMOS inverters 902 and 904, respectively, for receiving complementary clock signals clkin_p and clkin_n, respectively.

The AC-coupled buffer 901 includes the coupling capacitor Cc1 and a CMOS inverter 902. The CMOS inverter 902 includes an input node 940 at a voltage Vx, an output node 943 at a voltage clkout_b, a first path 941 to couple the input node 940 to the gate of a p-type transistor M11, a second path 945 to couple the input node 940 to the gate of an n-type transistor M01, and a feedback circuit 905.

The CMOS inverter 902 further includes, in series, a power supply node 942 at Vcc, M11, the output node 943, M01 and a ground node. M11 has a source coupled to the power supply node 942 and a drain coupled to the output node 943. M01 has a source coupled to the ground node and a drain coupled to the output node 943.

The feedback circuit 905 includes p-type and n-type transistors M41 and M51, respectively, having their gates coupled to one another via a node 971. M41 has a first source/drain terminal 946 coupled to a node 944 which in turn is coupled to the input node 940 and a second source/drain terminal 947 coupled to a node 969 which in turn is coupled to the output node 943. M51 has a first source/drain terminal 948 coupled to the node 944 and a second source/drain terminal 949 coupled to the node 969.

The AC-coupled buffer 903 can be configured similarly to the AC-coupled buffer 901. The AC-coupled buffer 903 includes a coupling capacitor Cc2 and a CMOS inverter 904. The CMOS inverter 904 can be configured similarly to the CMOS inverter 902. The CMOS inverter 904 includes an input node 950 at a voltage Vy, an output node 953 at a voltage clkout, a first path 951 to couple the input node 950 to the gate of a p-type transistor M10, a second path 955 to couple the input node 950 to the gate of an n-type transistor M00, and a feedback circuit 906.

The CMOS inverter 904 further includes, in series, a power supply node 952 at Vcc, M10, the output node 953, M00 and a ground node. M10 has a source coupled to the power supply node 952 and a drain coupled to the output node 953. M00 has a source coupled to the ground node and a drain coupled to the output node 953.

The feedback circuit 906 can be configured similarly to the feedback circuit 905. The feedback circuit 906 includes p-type and n-type transistors M40 and M50, respectively, having their gates coupled to one another via a node 981. M40 has a first source/drain terminal 956 coupled to a node 954 which in turn is coupled to the input node 950 and a second source/drain terminal 957 coupled to a node 960 which in turn is coupled to the output node 953. M50 has a first source/drain terminal 958 coupled to the node 954 and a second source/drain terminal 959 coupled to the node 960.

Additionally, a first cross-coupling path 970 couples the node 971 to the input node 950, and a second cross-coupling path 980 couples the node 981 to the input node 940. The first cross-coupling path 970 is to couple the input node 950 of the second AC-coupled buffer 903 to the variable-impedance circuit 905 of the first AC-coupled buffer 901, and the second cross-coupling path 980 is to couple the input node 940 of the first AC-coupled buffer 901 to the variable-impedance circuit 906 of the second AC-coupled buffer 903.

FIG. 10 depicts a circuit 1090 in which the circuit 990 of FIG. 9 is modified by providing cross-coupling paths 1070 and 1080 at the outputs instead of the inputs of the CMOS inverters 902 and 904, in accordance with various embodiments. In particular, a first cross-coupling path 1070 couples the node 981 to the output node 943, and a second cross-coupling path 1080 couples the node 971 to the output node 953.

The first cross-coupling path 1070 is to couple the variable-impedance circuit 905 of the first AC-coupled buffer 901 to the output node 953 of the second AC-coupled buffer 903, and the second cross-coupling path 1080 is to couple the variable-impedance circuit 906 of the second AC-coupled buffer 903 to the output node 943 of the first AC-coupled buffer 901.

The cross-coupling paths of FIGs. 9 and 10 have advantages including protecting the diode-based variable impedance. Also, the cross-coupling will average out the mismatch present in the positive (phase 0) and negative path (phase 180) of the clock which may improve the duty cycle of the differential clock.

FIG. 11 depicts plots indicating the operation of a differential clock path based on the AC-coupled buffer 350 of FIG. 3, in accordance with various embodiments. The plots are for simulation waveforms at 10 GHz clock frequency. Each plot is of voltage versus time. Plots 1100 and 1101 depict the CTLE outputs clkin_n and clkin_p, respectively, as plots of voltage versus time. Plots 1110 and 1111 depict the outputs of AC coupling capacitors in the clock paths which include clkin_n and clkin_p, respectively, as plots of voltage versus time. Plots 1120 and 1121 depict the final clock outputs of the AC-coupled buffers in the clock paths which include clkin_n and clkin_p, respectively, as plots of voltage versus time. Plot 1130 depicts a duty cycle versus time. Clkin_p is initially lower than clkin_n, resulting in a distortion in the final output clock which affects the duty cycle. The duty cycle settles gradually at a steady state level.

FIG. 12 depicts plots indicating the operation of the circuit 890 of FIG. 8B, in accordance with various embodiments. The plots are for simulation waveforms at 10 GHz clock frequency. Plots 1200 and 1201 depict the CTLE outputs clkin_n and clkin_p, respectively, at nodes 835 and 833, respectively, as plots of voltage versus time. Plots 1210 and 1211 depict the outputs of the AC coupling capacitors Cc2 and Cc1, respectively, as plots of voltage versus time. Plots 1220 and 1221 depict the final clock outputs clkout and clkout_b, respectively, at the output nodes 853 and 843, respectively, as plots of voltage versus time. Plot 1230 depicts a duty cycle versus time. There is only minor distortion in the final output clock which affects the duty cycle. In this case, duty cycle advantageously recovers in a significantly shorter time compared to FIG. 12, e.g., in just three to four clock cycles of the 10 GHz clock frequency.

FIG. 13 depicts plots comparing the operation of the circuit 890 of FIG. 8B to a differential clock path based on the AC-coupled buffer 350 of FIG. 3, respectively, in accordance with various embodiments. The plots are for simulation waveforms at 100 MHz clock frequency. Plots 1300 (circles) and 1303 (triangles) depict the CTLE outputs clkin_p and clkin_n, respectively, based on the AC-coupled buffer 350 of FIG. 3. Plots 1301 (squares) and 1302 (diamonds) depict the CTLE outputs clkin_p and clkin_n, respectively, based on the circuit of FIG. 8B. The peaks are lower in magnitude for the circuit of FIG. 8B.

Plots 1310 (circles) and 1313 (triangles) depict the outputs of the AC coupling capacitor for clkin_p and clkin_n, respectively, based on the AC-coupled buffer 350 of FIG. 3. Plots 1311 (squares) and 1312 (diamonds) depict the outputs of the AC coupling capacitor for clkin_p and clkin_n, respectively, based on the circuit of FIG. 8B. The peaks are lower in magnitude for the circuit of FIG. 8B.

Plots 1320 (circles) and 1323 (triangles) depict the outputs clkout_b and clkout, respectively, of the inverting amplifier or AC-coupled buffer of FIG. 3. Plots 1321 (squares) and 1322 (diamonds) depict the outputs clkout_b and clkout, respectively, of the inverting amplifier or AC-coupled buffer of the circuit of FIG. 8B. The peaks are lower in magnitude for the circuit of FIG. 8B.

In the comparative circuit solution of FIG. 3, the AC coupling capacitor outputs settle to the inverting amplifier's self-bias voltage after around 1ns, for example, and eventually the clock dies and the next inverter's output (clkout_b and clkout) also settles to its self-bias voltage. The AC-coupled buffer 350 of FIG. 3 has a constant resistance (Rf) and the voltage at the output of the AC coupling capacitors decays with an exponential rate depending on the time constant Rf*Cc.

In the circuit of FIG. 8B, zone 1 and zone 2 of the outputs of the AC coupling capacitor have very low and very high impedance, respectively. Therefore, the inverting amplifier will have a low gain in zone 1 and a high gain in zone 2. Accordingly, the duty cycle recovery time is small because of the initial low resistance in zone 1. Moreover, this approach can work until the clock reaches a extremely low frequency, because of high impedance of the diodes in zone 2.

FIG. 14 depicts plots comparing a current consumption of the AC-coupled buffer 801 or 803 of FIG. 8B (plot 1400, dashed line) to a current consumption of the AC-coupled buffer 350 of FIG. 3 (plot 1410, solid line with circles), in accordance with various embodiments. The vertical axis depicts current consumption and the horizontal axis depicts different process, voltage and temperature (PVT) corners.

A PVT corner refers to a specific combination of process, voltage, and temperature conditions that characterize the operating environment of an integrated circuit (IC). The process refers to variations in the manufacturing processes that can affect the performance and behavior of individual transistors and other components on the semiconductor chip. These variations include factors such as transistor dimensions, doping levels, and oxide thickness. Process variations can lead to differences in transistor speed, power consumption, and other characteristics.

Voltage refers to the operating voltage applied to the integrated circuit. Variations in voltage can affect the speed, power consumption, and reliability of the IC. Temperature refers to the operating temperature of the integrated circuit. Temperature variations can affect the speed, leakage current, and reliability of semiconductor devices.

The plots demonstrate that the power consumption remains essentially the same at different PVT corners.

Another advantage of the AC-coupled buffer 801 or 803 in the circuit 890 of FIG. 8B compared to the AC-coupled buffer 350 of FIG. 3 is that the removal of the resistor Rf reduces the area of the AC-coupled buffer by about one half. The layout thus becomes more compact and suitable for high-speed applications.

FIG. 15 illustrates an example of components that may be present in a computing system 1550 for implementing the techniques (e.g., operations, processes, methods, and methodologies) described herein. A clock circuit 1590 may include any of the AC-coupled buffers and clock path discussed herein, including those depicted in FIGs. 6- 10.

The computing system 1550 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1550, or as components otherwise incorporated within a chassis of a larger system. In an example implementation, the voltage regulator 1500 may provide a voltage to one or more of the components of the computing system 1550. In one approach, all or part of the computing system 1550 is provided in a SoP, System in Package (SiP) or a System on Chip (SoC).

The voltage regulator can provide a voltage Vout to one or more of the components of the computing system 1550. The memory circuitry 1554 may store instructions and the processor circuitry 1552 may execute the instructions to perform the functions described herein.

The system 1550 includes processor circuitry in the form of one or more processors 1552. The processor circuitry 1552 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1552 may include one or more hardware accelerators (e.g., same or similar to acceleration circuitry 1564), which may be microprocessors, programmable processing devices (e.g., FPGA, ASIC, etc.), or the like. The one or more accelerators may include, for example, computer vision and/or deep learning accelerators. In some implementations, the processor circuitry 1552 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein.

The processor circuitry 1552 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1552 may be coupled with or may include memory/storage and may be configured to execute instructions stored in the memory/storage to enable various applications or operating systems to run on the platform 1550. The processors (or cores) 1552 is configured to operate application software to provide a specific service to a user of the platform 1550. In some embodiments, the processor(s) 1552 may be a special-purpose processor(s)/controller(s) configured (or configurable) to operate according to the various embodiments herein.

As examples, the processor(s) 1552 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1552 may be a part of a system on a chip (SoC), System-in-Package (SiP), a multi-chip package (MCP), and/or the like, in which the processor(s) 1552 and other components are formed into a single integrated circuit, or a single package, such as the Edison^{™} or Galileo^{™} SoC boards from Intel^{®} Corporation. Other examples of the processor(s) 1552 are mentioned elsewhere in the present disclosure.

The system 1550 may include or be coupled to acceleration circuitry 1564, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1564 may comprise logic blocks or logic fabric and other interconnected resources that may be programmed (configured) to perform various functions, such as the procedures, methods, functions, etc. of the various embodiments discussed herein. In such implementations, the acceleration circuitry 1564 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1552 and/or acceleration circuitry 1564 may include hardware elements specifically tailored for machine learning and/or artificial intelligence (AI) functionality. In these implementations, the processor circuitry 1552 and/or acceleration circuitry 1564 may be, or may include, an AI engine chip that can run many different kinds of AI instruction sets once loaded with the appropriate weightings and training code. Additionally or alternatively, the processor circuitry 1552 and/or acceleration circuitry 1564 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphalCs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Testa^{®}, Inc., an Epiphany^{™} based processor provided by Adapteva^{®}, or the like. In some embodiments, the processor circuitry 1552 and/or acceleration circuitry 1564 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin provided by Huawei^{®}, and/or the like. In some hardware-based implementations, individual subsystems of system 1550 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1550 also includes system memory 1554. Any number of memory devices may be used to provide for a given amount of system memory. As examples, the memory 1554 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1554 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1554 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1558 provides persistent storage of information such as data, applications, operating systems and so forth. In an example, the storage 1558 may be implemented via a solid-state disk drive (SSDD) and/or high-speed electrically erasable memory (commonly referred to as "flash memory"). Other devices that may be used for the storage 1558 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1554 and/or storage circuitry 1558 may also incorporate three-dimensional (3D) cross-point (XPOINT) memories from Intel^{®} and Micron^{®}.

The memory circuitry 1554 and/or storage circuitry 1558 is/are configured to store computational logic 1583 in the form of software, firmware, microcode, or hardware-level instructions to implement the techniques described herein. The computational logic 1583 may be employed to store working copies and/or permanent copies of programming instructions, or data to create the programming instructions, for the operation of various components of system 1550 (e.g., drivers, libraries, application programming interfaces (APIs), etc.), an operating system of system 1550, one or more applications, and/or for carrying out the embodiments discussed herein. The computational logic 1583 may be stored or loaded into memory circuitry 1554 as instructions 1582, or data to create the instructions 1582, which are then accessed for execution by the processor circuitry 1552 to carry out the functions described herein. The processor circuitry 1552 and/or the acceleration circuitry 1564 accesses the memory circuitry 1554 and/or the storage circuitry 1558 over the interconnect (IX) 1556. The instructions 1582 direct the processor circuitry 1552 to perform a specific sequence or flow of actions, for example, as described with respect to flowchart(s) and block diagram(s) of operations and functionality depicted previously. The various elements may be implemented by assembler instructions supported by processor circuitry 1552 or high-level languages that may be compiled into instructions 1588, or data to create the instructions 1588, to be executed by the processor circuitry 1552. The permanent copy of the programming instructions may be placed into persistent storage devices of storage circuitry 1558 in the factory or in the field through, for example, a distribution medium (not shown), through a communication interface (e.g., from a distribution server (not shown)), over-the-air (OTA), or any combination thereof.

The IX 1556 couples the processor 1552 to communication circuitry 1566 for communications with other devices, such as a remote server (not shown) and the like. The communication circuitry 1566 is a hardware element, or collection of hardware elements, used to communicate over one or more networks 1563 and/or with other devices. In one example, communication circuitry 1566 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1566 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1556 also couples the processor 1552 to interface circuitry 1570 that is used to connect system 1550 with one or more external devices 1572. The external devices 1572 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1550, which are referred to as input circuitry 1586 and output circuitry 1584. The input circuitry 1586 and output circuitry 1584 include one or more user interfaces designed to enable user interaction with the platform 1550 and/or peripheral component interfaces designed to enable peripheral component interaction with the platform 1550. Input circuitry 1586 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1584 may be included to show information or otherwise convey information, such as sensor readings, actuator position(s), or other like information. Data and/or graphics may be displayed on one or more user interface components of the output circuitry 1584. Output circuitry 1584 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1550. The output circuitry 1584 may also include speakers and/or other audio emitting devices, printer(s), and/or the like. Additionally or alternatively, sensor(s) may be used as the input circuitry 1584 (e.g., an image capture device, motion capture device, or the like) and one or more actuators may be used as the output device circuitry 1584 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1550 may communicate over the IX 1556. The IX 1556 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1556 may be a proprietary bus, for example, used in a SoC based system.

The number, capability, and/or capacity of the elements of system 1550 may vary, depending on whether computing system 1550 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 1550 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a p-type transistor coupled in series with an n-type transistor, wherein the p-type transistor is coupled to a power supply node and the n-type transistor is coupled to a ground;
an input node coupled to a gate of the p-type transistor and a gate of the n-type transistor;
an output node coupled between the p-type transistor and the n-type transistor; and
a circuit to couple the input node to the output node, wherein the circuit has a variable impedance.

2. The apparatus of claim 1, further comprising:
a capacitor coupled to the input node; and
one or more continuous time linear equalizer stages, or other driver circuitry, coupled to the capacitor.

3. The apparatus of claim 1 or 2, wherein the circuit comprises a first diode-connected n-type transistor having a control gate and a drain coupled to the input node, and a second diode-connected n-type transistor having a control gate and a drain coupled to the output node.

4. The apparatus of claim 1 or 2, wherein the circuit comprises a first diode-connected p-type transistor having a control gate and a drain coupled to the input node, and a second diode-connected p-type transistor having a control gate and a drain coupled to the output node.

5. The apparatus of claim 1 or 2, wherein the circuit comprises a diode-connected n-type transistor having a control gate coupled to the input node, and a diode-connected p-type transistor having a control gate coupled to the input node.

6. The apparatus of claim 1 or 2, wherein the circuit comprises a diode-connected n-type transistor having a control gate coupled to the output node, and a diode-connected p-type transistor having a control gate coupled to the output node.

7. The apparatus of any one of claims 1-6, wherein the circuit comprises:
a first transmission gate having a first input/output node coupled to the input node and a second input/output node coupled to the output node; and
a second transmission gate having a third input/output node coupled to the input node and a fourth input/output node coupled to the output node.

8. The apparatus of any one of claims 1-7, wherein the circuit comprises a plurality of diode-connected transistors coupled between the input node via a first resistor and to the output node via a second resistor, and the first and second resistors comprise at least one of polysilicon resistors or resistors implemented with transistors.

9. The apparatus of any one of any one of claims 1-8, further comprising a capacitor coupled to the input node, wherein the p-type transistor, the n-type transistor, the input node, the output node, the circuit, and the capacitor are part of an alternating-current (AC)-coupled buffer, and the AC-coupled buffer is provided in at least one of an integrated circuit, a System-on-Chip, a System-in-Package, or a computing device.

10. The apparatus of any one of claims 1-8, further comprising a capacitor coupled to the input node, wherein:
the p-type transistor, the n-type transistor, the input node, the output node, the capacitor and the circuit are part of a first alternating-current (AC)-coupled buffer in a differential clock path;
the apparatus further comprises a second AC-coupled buffer in the differential clock path;
the second AC-coupled buffer comprises a variable-impedance circuit coupled between an input node and
an output node; and
a clock of the first AC-coupled buffer is complementary to a clock of the second AC-coupled buffer.

11. The apparatus of claim 10, further comprising:
a first cross-coupling path to couple the input node of the second AC-coupled buffer to the variable-impedance circuit of the first AC-coupled buffer; and
a second cross-coupling path to couple the input node of the first AC-coupled buffer to the variable-impedance circuit of the second AC-coupled buffer.

12. The apparatus of claim 10, further comprising:
a first cross-coupling path to couple the variable-impedance circuit of the first AC-coupled buffer to the output node of the second AC-coupled buffer; and
a second cross-coupling path to couple the variable-impedance circuit of the second AC-coupled buffer to the output node of the first AC-coupled buffer.

13. A method, comprising:
receiving a clock signal in a first power supply domain at an input node;
coupling the clock signal to control gates of p-type and n-type transistors in series and to a variable-impedance feedback circuit; and
outputting a clock signal in a second power supply domain from an output node coupled to the p-type and
n-type transistors and the variable-impedance feedback circuit.

14. The method of claim 13, wherein:
the p-type transistor is coupled to a power supply node and the n-type transistor is coupled to a ground;
the input node is coupled to a gate of the p-type transistor and a gate of the n-type transistor;
the output node is coupled in series between the p-type transistor and the n-type transistor;
a capacitor is coupled to the input node;
the capacitor is in a path of a clock signal. ;
a first transistor is coupled to the input node and to the output node;
a second transistor is coupled to the input node and to the output node; and impedances of the first and
second transistors are to vary when the clock signal is received at the input node.

15. The method of claim 14, wherein the first and second transistors are diode-connected transistors.
